**Europäisches Patentamt**

**European Patent Office**

**Office européen des brevets**

(19)

(11) Veröffentlichungsnummer: **0 264 686 B1**

(12) **EUROPÄISCHE PATENTSCHRIFT**

(45) Veröffentlichungstag der Patentschrift:
27.12.90

(51) Int. Cl.⁵: **H05K 7/14**

(21) Anmeldenummer: 87114379.8

(22) Anmeldetag: 02.10.87

(54) Mit Profilschienen eines Baugruppenträgers verbindbare Halteschiene.

(30) Priorität: 09.10.86 DE 3634462

(43) Veröffentlichungstag der Anmeldung:
27.04.88 Patentblatt 88/17

(45) Bekanntmachung des Hinweises auf die Patenterteilung:
27.12.90 Patentblatt 90/52

(84) Benannte Vertragsstaaten:
AT CH DE ES FR GB IT LI NL SE

(56) Entgegenhaltungen:
EP-A- 0 025 953
DE-A- 2 810 658
DE-B- 2 554 106
DE-U- 8 527 875
FR-A- 1 578 065

(73) Patentinhaber: Licentia Patent-Verwaltungs-GmbH,
Theodor-Stern-Kai 1, D-6000 Frankfurt/Main 70(DE)

(72) Erfinder: Haxel, Gerd, Danziger Strasse 38,
D-6453 Seligenstadt(DE)
Erfinder: Bohnenberger, Willy, Goethe Strasse 8,
D-6451 Mainhausen(DE)
Erfinder: Hörbe, Siegfried, An der Hohl 3,
D-6393 Wehrheim(DE)
Erfinder: Ponto, Robert, Grabenstrasse 21,
D-6453 Seligenstadt(DE)

(74) Vertreter: Lertes, Kurt, Dr. et al, Licentia
Patent-Verwaltungs-GmbH Theodor-Stern-Kai 1,
D-6000 Frankfurt/M 70(DE)

EP 0 264 686 B1

## Beschreibung

Die Erfindung bezieht sich auf eine Vorrichtung mit mindestens einem mit Profilschienen eines Baugruppenträgers verbindbaren Führungshalter für Baugruppen, die auf einer Leiterplatte angeordnete elektrische oder elektronische Bauteile und wahlweise eine Frontplatte aufweisen.

Es ist in Führungshalter bekannt, der zwei integrierte Halteelemente aufweist, die jeweils über zwei einander gegenüberliegende und quer zur Längsachse des Führungshalters verlaufende federnde Elemente in entsprechende Ausnehmungen von Querschienen eines Baugruppenträgers einrasten. Der bekannte Führungshalter weist eine Nut auf, die für die Aufnahme des Randes der Leiterplatte der jeweiligen Baugruppe bestimmt ist. An den Enden der Führungshalter springen jeweils zwei Führungsstifte vor, die in zwei nebeneinanderliegende Öffnungen der Profilschienen ragen (DE-PS 25 54 106). Bekannt ist auch ein Baugruppenträger, der mit Profilschienen verbundene Führungshalter aufweist, in die Leiterplatten von Baugruppen einschiebbar sind. Auf der jeweiligen Leiterplatte ist eine Leiterbahn angeordnet, die ein elektrisch gut leitenden Kontakt mit den metallischen Befestigungsmitteln der Frontplatte steht. An der vorderen Profilschiene des Baugruppenträgers ist ein Schleifkontakt befestigt, der mit der Leiterbahn elektrisch leitend verbunden ist. Da die Profilschienen aus Metall bestehen, wird über den Schleifkontakt eine leitende Verbindung zwischen der Frontplatte, der Leiterbahn und der Profilschiene hergestellt, die an eine Gestellerdung angeschlossen ist (DE-OS 28 44 576).

Der Erfindung liegt die Aufgabe zugrunde, einen Führungshalter der eingangs beschriebenen Gattung derart weiterzuentwickeln, daß auf möglichst einfache Weise eine elektrisch gut leitende Verbindung zwischen einer Leiterbahn auf der Leiterplatte und mindestens einer Profilschiene oder einer anderen Bezugspotential führenden Stelle des diesen enthaltenden Schranks oder Gestells hergestellt werden kann.

Die Aufgabe wird erfindungsgemäß durch die Anspruch 1 beschriebenen Maßnahmen gelöst. Mit der im Anspruch 1 angegebenen Vorrichtung kann für mehrere Baugruppen eine gemeinsame Erdpotentialverbindung mit geringem Kontaktübergangswiderstand hergestellt werden. Eine derartige Erdung ist vielfach erforderlich, um Störungen durch Erdströme zu vermeiden, die dann auftreten, wenn elektrische Schaltungen an mehreren Stellen bei unterschiedlichen Übergangswiderständen geerdet sind.

Vorzugsweise enthält die Halteeinrichtung außerhalb des Verschiebewegs für die Baugruppen angeordnete Auflagestellen für einen mittleren Abschnitt der jeweiligen Blattfeder sowie je eine Durchgangsöffnung im Führungshalter für eine erste und zweite Fahne, die in Richtung der Durchgangsöffnungen abgewinkelt, je von den Enden des mittleren Abschnitts ausgehen und sich an Vertiefungen der Wände der Durchgangsöffnungen abstützen, die Federn werden durch ihre eigene Federspannung mit Teilen der Fahnen an die Vertiefung angedrückt, so daß sie unverlierbar einrasten.

Zweckmäßigerweise ragt eine Fahne der eine Leiterbahn mit der Profilschiene leitend verbindenden Blattfeder über die eine Durchgangsöffnung hinaus und ist gegen eine an die Durchgangsöffnung angrenzende Seite der Profilschiene angedrückt, während die andere Fahne mit ihrem abgewinkelten Ende in die Vertiefung ragt. Die Feder läßt sich von Hand schnell und einfach in den Führungshalter einrasten. Danach kann der Führungshalter an der jeweiligen Profilschiene befestigt werden, wobei eine Fahne gegen eine Seite der Profilschiene gedrückt wird. Der Montageaufwand ist daher sehr gering.

Bei einer bevorzugten Ausführungsform ragt eine Fahne der eine Leiterbahn mit einer Leitung verbindenden Feder über die der Profilschienen abgewandte Durchgangsöffnung hinaus, während die andere Fahne mit ihrem abgewinkelten Ende sich in der Vertiefung abstützt. Diese Feder, die bei Bedarf für eine bestimmte Art der Erdung (Sternpunkterdung) eingesetzt wird, läßt sich ebenfalls schnell und einfach von Hand in Führungshalter einrasten. Es ist günstig, wenn die aus der Durchgangsöffnung herausragende Fahne an ihrem Ende als Steckkontakt ausgebildet ist, damit die Leistungen zu einer mehreren Baugruppen gemeinsamen Erdungsstelle ohne großen Zeitaufwand angeschlossen werden können.

Bei einer besonders zweckmäßigen Ausführungsform weist der Führungshalter an mindestens einer Stirnseite eine Halteeinrichtung für eine Feder auf, die einen Z-förmig gebogenen Grundkörper enthält, dessen eines Ende unter Federvorspannung gegen eine Seite in einer Aussparung der Profilschiene andrückbar ist, während vom anderen Ende des Grundkörpers, der von der Stirnseite der Führungsnut angeordnet ist, eine tulpenförmige Kontaktfeder vorspringt, zwischen die ein Messerkontakt einsetzbar ist, der mit der Frontplatte der Baugruppe verbunden ist. Mit dieser Ausführungsform ist es möglich, ohne Beanspruchung eines Kontakts des Steckverbinders die Frontplatte des Baugruppenträgers, z.B. zu Schutz- und/oder Abschirmzwecken, voreilend zu erden und eine Systemmeldung über die andere Feder herzustellen, die an einer Leiterbahn der Leiterplatte anliegt. Die metallische oder metallisiert Frontplatte kann bedarfsweise mit Leiterbahnen auf der Leiterplatte verbunden sein. Die Ausführungsform eignet sich für Baugruppen, deren Bauteile höhere Spannungen benötigen, da über die Frontplatten und an diese angeschlossene Leiterbahnen eine Schutzerdung und eine davon gesonderte Betriebserdung oder Nullung möglich ist.

Bei einer anderen zweckmäßigen Ausführungsform sind nahe an den beiden Enden des Führungshalters jeweils in Längsrichtung der Profilschiene nebeneinander eine mit einer Aussparung der Profilschiene fluchtendes Loch und ein in ein Loch der Profilschiene einsetzbarer Führungsstift angeordnet, neben dem eine Kante einer Aussparung der Profilschiene hintergreifender Rasthaken vom Führungshalter vorspringt. Diese Ausführungsform erlaubt es, den Führungshalter zur Erzielung einer sehr festen Verbindung an der Profilschiene anzuschrauben. Zur Erleichterung des Anschraubens kann vorzugsweise eine Mutter an einem Ende des Lochs in eine Ausnehmung des Führungshalters eingepreßt werden. Es kann jedoch auch mit Schneidschrauben gearbeitet werden. Vor dem Anschrauben werden die Führungshalter in der richtigen Position durch Rastverbindungen an den Profilschienen befestigt. Zum Anschrauben der Führungshalter an den Profilschienen sind dann keine komplizierten Handgriffe mehr erforderlich. Bei einer anderen günstigen Ausführungsform ist eine wahlweise Schraub- und Steckverbindung zwischen Führungshalter und Profilschienen möglich. Dieser Führungshalter enthält jeweils an den Enden nebeneinander einen Führungsstift, der in ein Loch der Profilschiene greift, und ein Loch für eine Befestigungsschraube. Neben dem Führungsstift und neben dem Loch befinden sich unmittelbar an den Rändern des Führungshalters je ein Paar Rasthaken, die hinter einer Kante einer Aussparung der Profilschiene einrasten. Bei einer anderen bevorzugten Ausführungsform weist der Führungshalter zwei entlang der Grenzen der jeweiligen Baugruppenteilung im Baugruppenträger verlaufende Längsleisten auf die durch Querstege miteinander verbunden sind. Eine Leiste enthält einen Absatz als Gleitfläche für die Leiterplatte des jeweiligen Baugruppenträgers. In einem an die Stärke der Leiterplatte angepaßten Abstand von der Leiste befinden sich auf den Querträgern Vorsprünge, die als Führung für die Leiterplattenkante bestimmt sind. Diese Anordnung hat eine hohe Festigkeit bei guter Luftdurchlässigkeit, insbesondere unmittelbar an der Bestückungsseite. Deshalb eignet sich diese Vorrichtung insbesondere für lange Führungshalter sowie für hohe Anforderungen wie Vibration, Schock usw.

Die Erfindung wird im folgenden an Hand eines in einer Zeichnung dargestellten Ausführungsbeispiels näher beschrieben, aus dem sich weitere Einzelheiten, Merkmale und Vorteile ergeben.

Es zeigen:

Fig. 1 eine Hälfte eines Führungshalters von oben,

Fig. 2 eine Hälfte eines Führungshalters von unten,

Fig. 3 einen Schnitt durch den mit einer vorderen Profilschiene verbundenen Teil eines Führungshalters, der mit einer Baugruppe und mit Federn bestückt ist,

Fig. 4 die in Fig. 3 dargestellte Vorrichtung von oben,

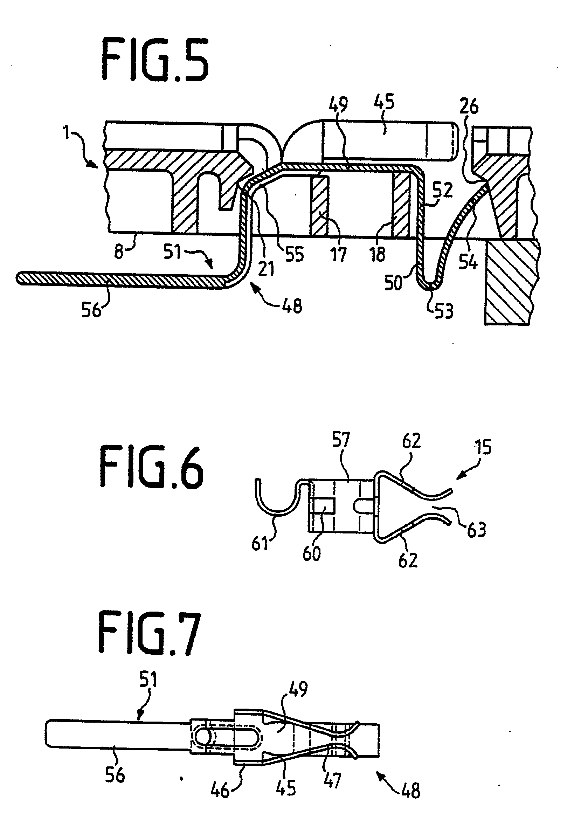

Fig. 5 einen Schnitt durch den an einer vorderen Profilschiene angrenzenden Teil eines Führungshalters, der mit einer anderen Art von Feder bestückt ist,

Fig. 6 eine Ansicht von oben der in Fig. 3 dargestellten Feder,

Fig. 7 eine Ansicht von oben der in Fig. 5 in Verbindung mit dem Führungshalter dargestellten Feder.

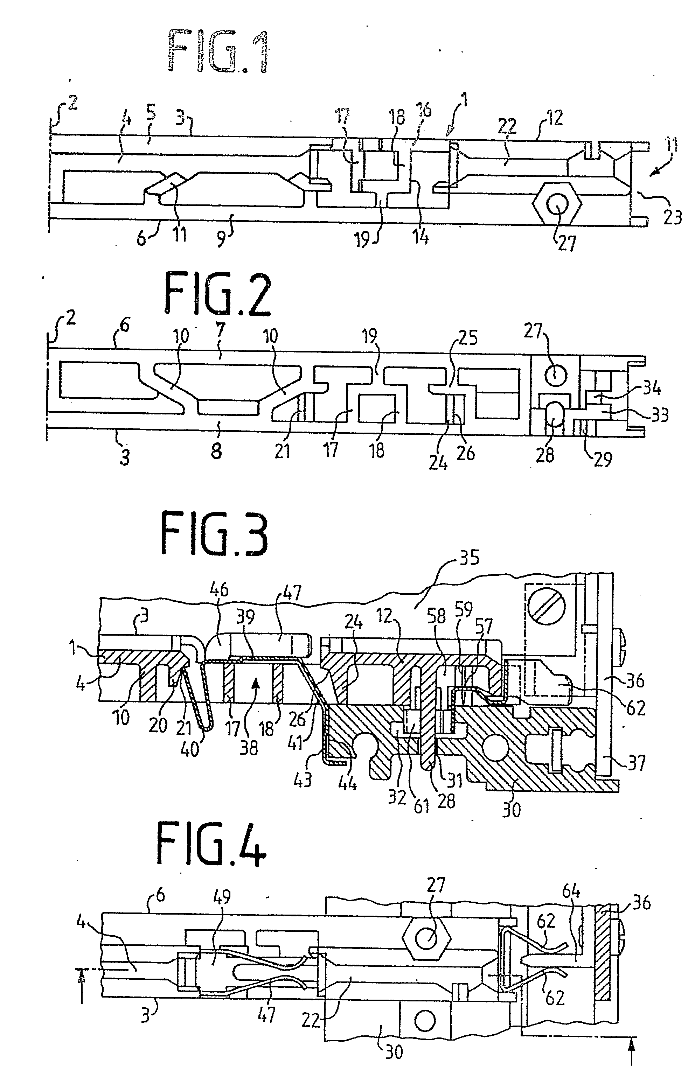

Die Fig. 1 zeigt eine Hälfte eines Führungshalters 1, der zu einer Symmetrielinie 2 spiegelsymmetrisch ausgebildet ist. Der Führungshalter 1 enthält an einer Seite eine Längsleiste 3, von der eine Querleiste 4 vorspringt, die gegen die eine Schmalseite 5 der Längsleiste 3 um ein Stück zurückgesetzt ist, das sich nach der Höhe des für die Führung verfügbaren Rands der Leiterplatte richtet, die vom Führungshalter 1 auf einer Seite gehalten wird. Im Abstand der für Baugruppen in Baugruppenträgern vorgesehenen Teilung verläuft zur Längsleiste 3 eine zweite Längsleiste 6 parallel, die auf ihrer einen Schmalseite 7 fluchtend zu der Schmalseite 8 der Längsleiste angeordnet ist. Die andere Schmalseite 9 der Längsleiste 6 ist um den Abstand der Querleiste 4 von der Schmalseite 5 kleiner als die Längsleiste 3.

Zwischen den Längsleisten 3 und 6 sind fachwerkartig Querträger 10 angeordnet, die bis auf ihre an die Querleiste 4 angrenzenden Abschnitte die gleiche Höhe wie die Leiste 6 haben. An ihren der Querleiste 4 benachbarten Stellen enthalten die Querträger 10 Vorsprünge 11, deren Höhe dem Niveau der Schmalseite 5 entspricht.

Ein von der Stirnseite des Führungshalters 1 ausgehender Bereich 12 befindet sich in eingebauter Lage des Führungshalters 1 auf der Profilschiene 30. An den Bereich 12 schließt sich eine Halteeinrichtung 14 für unterschiedlich ausgebildete Federn 38, 48 an. An der Halteeinrichtung 14 ist in der Längsleiste 3 eine Ausnehmung 16 vorgesehen, die sich bis unter das Niveau der Querleiste 4 erstreckt. Im Hohlraum zwischen den beiden Längsleisten 3 und 6 sind zwei rechtwinklig zu den Längsleisten 3 und 6 verlaufende Stege 17, 18 vorgesehen, die U-förmig ineinander übergehen und über ein gemeinsames Verbindungsstück 19 mit der Längsleiste 6 verbunden sind. Die Querleiste 4 endet an der Rasteinrichtung 14 in einem in den Raum mit den Stegen 17, 18 abgewinkelten Abschnitt 20, der eine dem Steg 17 zugewandte, kantenförmige Vertiefung 21 enthält.

Im Abstand der Länge der Rasteinrichtung 14 vom Abschnitt 20 beginnt im Bereich 12 eine Nut 22, die sich bis zur Stirnseite des Führungshalters 1 erstreckt. An der Stirnseite ist eine U-förmige Aufnahmeöffnung 23 vorgesehen, die durch eine Verlängerung eines Teils der 3, 6 über Längsleisten die Stirnseite hinaus gebildet wird. Am inneren Ende der Nut 2 ist ein weiterer abgewinkelter Abschnitt 24 vorgesehen, der sich vom Nutboden bis zum Niveau der Schmalseiten 7, 8 erstreckt und mit einer Seite an die Längsleiste 6 angrenzt. Die andere Seite grenzt an eine kurze Längswand 25 an, die über einen nicht näher bezeichneten Steg mit der Längsleiste 3 verbunden ist. Der Abschnitt 24 enthält eine dem Steg 18 zugewandte Vertiefung 26. Die Nut 22 beansprucht mit den Seitenwänden eine Hälfte der Breite des Führungshalts 1 im Bereich 12. Die andere Hälfte weist ein Loch 27 auf, dessen Mittelachse parallel zu den Seitenwänden des Führungshalters 1 verläuft. Unterhalb der Nut 22 befindet sich neben dem Loch 27 ein Zapfen 28, vor dem, in Längsrichtung des Führungshalters 1, ein Rasthaken 29 angeordnet ist. Der Zapfen 28 und das Loch 27 sind nebeneinander so angeordnet, daß der Zapfen 28 in mit einer Profilschiene 30 verbundener Stellung des Führungshalters in ein Loch 31 am Boden einer T-förmigen Profilausnehmung 32 ragt, während das Loch 27 fluchtend mit einem weiteren Loch am Boden der Profilausnehmung 32 angeordnet ist und eine Befestigungsschraube aufnimmt. die in Fig. 3 nicht näher dargestellt ist.

Zwischen der Stirnseite und dem Rasthaken 29 bzw. einem das Loch 27 enthaltenden massiven Teil des Führungshalters 1 befindet sich ein nach einer Seite offener Raum 33, in den eine Nase 34 ragt. Der Raum 33 bildet mit der Nase 34 und der Nut 23 eine Halteeinrichtung für eine weitere Feder 15, die unten noch beschrieben wird.

In Fig. 3 ist ein mit einer Profilschiene 30 verbundener Führungshalter 1 dargestellt. Der Bereich 12 liegt auf der Profilschiene 30, wobei der Zapfen 28 in das Loch 31 ragt. In die Nut 22 ist eine Leiterplatte 35 einer Baugruppe eingesetzt, die eine Frontplatte 36 enthält, die sich in eingeschobener Stellung der Baugruppe mit dem unteren Rand 37 gegen die vordere Seite der Profilschiene 30 legt. In die Halteeinrichtung 14 ist eine längliche Blattfeder 38 eingesetzt, die einen mittleren Abschnitt 39 enthält, der auf den beiden Stegen 17, 18 aufliegt und z.B. Aussparungen aufweist, in die nicht näher dargestellte Hacken der Stege 17, 18 ragen. Der mittlere Abschnitt 39 setzt sich zu beiden Seiten je in einer Fahne 40, 41 fort, die vom mittleren Abschnitt 39 abgewinkelt sind. Die Fahne 40 ist an einer Stelle 42 umgebogen und stützt sich mit ihrem Ende in der Vertiefung 21 ab. Die Fahne 41 ragt über den Raum zwischen dem Steg 18 und dem Abschnitt 24 mit einem Abschnitt 43 hinaus, der unter Federvorspannung gegen eine schmale Längsseite 44 der Profilschiene 30 anliegt. Von den Längsseiten des mittleren Abschnitts 39 ragen jeweils rechtwinklig abgebogene Kontaktfahnen 45 in den Bereich der Führungsbahn der Leiterplatte. Die Kontaktfahnen 45 sind je mit einer Basis 46 am mittleren Abschnitt 39 befestigt, während ein federndes Ende 47 in Längsrichtung der Führungsbahn der Leiterplatte 35 angeordnet ist. Wenn die Leiterplatte 35 nicht in den Führungshalter 1 eingesetzt ist, dann haben die federnden Enden 47 auf ihren den Basen 46 abgewandten Seiten einen Abstand, der kleiner als die Leiterplattenbreite ist. In eingeschobener Lage der Leiterplatte 35 legen sich die Enden 47 unter Federvorspannung an diese an. Auf der Leiterplatte 35 befinden sich an den Auflagestellen zumindest der vollständig in den Führungshalter 1 eingeschobenen Leiterplatte 35 Leiterbahnen, die nicht näher dargestellt sind. Diese Leiterbahnen werden von Blattfeder 38 mit der aus Metall bestehenden Profilschiene 30 leitend verbunden. Die Profilschienen 30 sind über die nicht dargestellten, metallischen Seitenwände des Baugruppenträgers an Massepotential gelegt. Damit kann die Masseverbindung zwischen der Profilschiene und der Leiterplatte 35 ohne einen Kontakt der Messerleiste hergestellt werden. Die Enden 47 lassen sich mit einer länglichen Kontaktauflagezone ausbilden, so daß die Masseverbindung auch dann vorhanden ist, wenn keine elektrische Verbindung zwischen der Messer- und der Federleiste an der Leiterplatte 35 bzw. am Baugruppenträger vorhanden ist. An Stelle der Blattfeder 38 kann in die Halteeinrichtung 14 auch eine Blattfeder 48 eingesetzt werden, die gewisse Übereinstimmung mit der Blattfeder 38 hat. Die Blattfeder 48 hat einen mittleren Abschnitt 49, an den sich zwei Fahnen 50, 51 anschließen. Von den Längsseiten des mittleren Abschnitts 49 ragen in gleicher Weise wie bei der Blattfeder 38 die rechtwinklig abgebogenen Kontaktfahnen 45 in die Führungsbahn der Leiterplatte 35. Die Kontaktfahnen 45 haben die gleiche Form wie bei der Blattfeder 38.

Die Fahne 50 grenzt mit einem rechtwinklig gegen den mittleren Abschnitt 49 abgebogenen Stück 52 an den Steg 18 an und ragt über den Führungshalter 1 hinaus. Das Stück 52 geht an einer Krümmungsstelle 53 in einen Endabschnitt 54 über, dessen Rand sich in der Vertiefung 26 abstützt. Hierdurch erhält die Blattfeder 48 eine Federvorspannung, die in Richtung der Vertiefung 21 wirkt und eine Wölbung 55 der Blattfeder 48 in die Vertiefung 21 drückt. Die Fahne 51 ragt mit einem Ende 56 über den Führungshalter 1 hinaus. Das Ende 56 ist steckkontaktförmig ausgebildet und verläuft im Abstand von der Schmalseite 8 in etwa parallel zu dieser.

Mit der Blattfeder 48 kann eine Leiterbahn auf der Leiterplatte 35 durch eine an das Ende 56 angeschlossene Leitung, die nicht dargestellt ist, an eine Masseverbindung im Baugruppenträger oder in einem Schrank bzw. Gestell angeschlossen werden. Diese Masseverbindung ist mehreren Baugruppen gemeinsam. Eine derartige Verbindung ist vielfach notwendig, wenn die auf verschiedenen Baugruppen angeordneten Schaltungen gemeinsam geerdet werden müssen, um die über Erdungen an verschiedenen Stellen eingekoppelten Störspannungen und -ströme zu unterbinden.

Während mit der Blattfeder 48 eine Betriebserdung (oder Nullung) erzeugt werden kann, ist eine Feder 15 für die Herstellung einer gegebenenfalls notwendigen Schutzerdung vorgesehen. Die Feder 15 hat einen Z-förmigen gebogenen Grundkörper 57, dessen eines Teil innerhalb der Aufnahmeöffnung 23 liegt. Das Mittelteil des Grundkörpers 57 erstreckt sich in dem Raum zwischen der Profilschiene 30 und dem Boden des Bereichs 12, der einen von dem Boden der Nut 22 bzw. dem neben der Nut 22 liegenden Führungshalterteil und den Längsleisten 3 und 6 begrenzten Hohlraum 58 aufweist. In den Hohlraum 58 ragt eine Nase 59, die in eine Ausnehmung 60 des Mittelteils des Grundkörpers 57 eingreift und damit die Feder 15 gegen eine Verschiebung in Längsrichtung des Führungshalters 1 sichert.

Vom zweiten Teil des Z-förmigen Grundkörpers 57 springt ein bogenförmiger Federabschnitt 61 vor. Der Federabschnitt 61 und das zugehörige Teil des Z-förmigen Grundkörpers 57 ragen in die T-förmige Profilausnehmung 32. Dabei liegt der bogenförmige Federabschnitt 61 an einer Seite der Profilausnehmung 32 an, während der zweite Teil des Z-förmigen Grundkörpers 57 an der anderen Seite der Profilausnehmung 32 unter Federvorspannung anliegt. Hierdurch wird eine niederohmige Verbindung zwischen der Feder 15 und der Profilschiene 30 hergestellt.

Vom ersten Teil des Z-förmigen Grundkörpers 57 springen an zwei einander gegenüberliegenden Seiten gabelförmig Kontaktfedern 62 vor, die sich bis auf einen Spalt 63 einander nähern. Mit der Frontplatte 36 ist ein Messerkontakt 64 verbunden, der bei in ein Paar Führungshalter 1 eingesetzter Baugruppe in die Kontaktfedern 62 eingreift. Durch die Feder 15 wird eine leitende Verbindung zwischen der Frontplatte 36 und gegebenenfalls der an diese angeschlossenen leitenden Teile der Leiterplatte 35 und der Profilschiene 30 hergestellt.

Von besonderer Bedeutung ist die Ausbildung der Halteeinrichtung 14, die für die Aufnahme von unterschiedlichen Blattfedern 38, 48 ausgebildet ist, die wahlweise eingesetzt werden, um die Leiterplatte mit der Profilschiene oder mit einem Systemnull zu verbinden. Die Halteeinrichtung 14 ist nahe an den beiden Enden des Führungshalters vorhanden, d.h. es kann in eine Halteeinrichtung 14 eine Blattfeder 38 und in die andere Halteeinrichtung 14 des Führungshalters die Blattfeder 48 eingesetzt werden, wenn die Leiterbahnen auf der Leiterplatte entsprechend ausgebildet sind. Es ist auch möglich die Feder 15 zusammen mit einer Blattfeder 38 bzw. 48 oder mit beiden zu verwenden.

**Patentansprüche**

1. Vorrichtung mit mindestens einem mit Profilschienen eines Baugruppenträgers verbindbaren Führungshalter für Baugruppen, die auf einer Leiterplatte angeordnete elektrische oder elektronische Bauteile und wahlweise eine Frontplatte enthalten,
**dadurch gekennzeichnet,**
daß mindestens in einem sich innen im Baugruppenträger an eine Profilschiene (30) anschließenden Bereich eine Halteeinrichtung (14) für zwei wahlweise einsetzbare verschieden ausgebildete Blattfedern (38, 48) vorgesehen ist, die jeweils mit einer Kontaktfahne (45) an eine leitende Stelle der jeweiligen Leiterplatte (35) andrückbar sind und die entweder als mit einer Fahne (41) an die Profilschiene (30) andrückbare Blattfeder (38) oder als eine Blattfeder (48) ausgebildet sind, die eine über den Führungshalter (1) auf der der Leiterplatte (35) entgegengesetzten Seite hinausragende Fahne (51) für den Anschluß einer Leitung aufweist.

2. Vorrichtung nach Anspruch 1, **dadurch gekennzeichnet,**
daß die Halteeinrichtung (14) außerhalb des Verschiebewegs für die Baugruppen angeordnete Auflagestellen für einen mittleren Abschnitt (39, 49) der jeweiligen Blattfeder (38, 48) sowie je eine Durchgangsöffnung im Führungshalter (1) für eine erste und zweite Fahne (41, 50; 40, 51) enthält, die - in Richtung der Durchgangsöffnungen abgewinkelt je von den Enden des mittleren Abschnitts (39, 49) ausgehen und sich an Vertiefungen (26, 21) der Wände der Durchgangsöffnungen abstützen.

3. Vorrichtung nach Anspruch 1 oder 2, **dadurch gekennzeichnet,**
daß eine Fahne (41) der eine Leiterbahn der Leiterplatte mit der Profilschiene (30) leitend verbindenden Blattfeder (38) über die eine Durchgangsöffnung hinausragt, ist gegen eine an die Durchgangsöffnung angrenzende Seite der Profilschiene (30) angedrückt, während die andere Fahne (40) mit ihrem abgewinkelten Ende in die Vertiefung (21) ragt.

4. Vorrichtung nach Anspruch 1 oder 2, **dadurch gekennzeichnet,**
daß eine Fahne (51) der eine Leiterbahn auf der Leiterplatte mit der Leitung verbindenden Feder (48) über die der Profilschiene (30) abgewandte Durchgangsöffnung hinausragt, während die andere Fahne (50) mit ihrem abgewinkelten Ende sich in der Vertiefung (26) der Seite der anderen Durchgangsöffnung abstützt.

5. Vorrichtung nach einem der vorhergehenden Ansprüche, **dadurch gekennzeichnet,**
daß an mindestens einer Stirnseite eine weitere Halteeinrichtung für eine Feder (15) vorgesehen ist, die einen Z-förmigen Grundkörper (57) enthält, dessen eines Ende unter Federvorspannung gegen eine Seite einer Aussparung (32) der Profilschiene (30) andrückbar ist, während vom anderen Ende des Grundkörpers (57), der vor der Stirnseite unterhalb der Führungsnut (22) angeordnet ist, eine tulpenförmige Kontaktfeder (62) vorspringt, zwischen die ein Messerkontakt (64) einsetzbar ist, der mit der Frontplatte (36) der Baugruppe verbunden ist.

6. Vorrichtung, insbesondere nach einem der vorhergehenden Ansprüche, **dadurch gekennzeichnet,**
daß nahe an den beiden Enden jeweils in Längsrichtung der Profilschiene (30) nebeneinander ein mit einer Aussparung in der Profilschiene (30) fluchtendes Loch (27) und ein in ein Loch der Profilschiene einsetzbarer Führungsstift (28) angeordnet sind, neben dem eine Kante einer Aussparung (32) der Profilschiene (30) hintergreifender Rasthaken (29) vom Führungshalter (1) vorspringt.

7. Vorrichtung, insbesondere nach einem der Ansprüche 1 bis 5, **dadurch gekennzeichnet,**
daß nahe an den Enden jeweils in Längsrichtung der Profilschienen (30) nebeneinander ein Führungsstift, der in ein Loch der Profilschiene eingreift und ein Loch für eine Befestigungsschraube vorgesehen sind und daß neben dem Führungsstift und neben dem Loch unmittelbar an den Rändern des Führungshalters je ein Paar Rasthaken angeordnet sind, die hinter einer Kante einer Aussparung der Profilschiene einrasten.

8. Vorrichtung, insbesondere nach einem der vorhergehenden Ansprüche, **dadurch gekennzeichnet,**
daß zwei entlang der Grenzen der jeweiligen Baugruppenteilung im Baugruppenträger verlaufende Längsleisten (3, 6) vorgesehen sind, die durch Querstege (10) miteinander verbunden sind.

9. Vorrichtung nach Anspruch 8, **dadurch gekennzeichnet,**
daß von einer Längsleiste eine Querleiste (4) als Führungsfläche für eine Leiterplattenkante vorspringt.

10. Vorrichtung nach Anspruch 8 oder 9, **dadurch gekennzeichnet,**

daß von den Querstegen (10) Vorsprünge (11) neben der Führungsfläche emporragen.

## Revendications

1. Dispositif comportant au moins un support de guidage, pouvant être relié à des rails profilés d'un support de groupes de composants, pour des groupes de composants qui contiennent des composants électriques ou électroniques, disposés sur une plaque de circuits et en option, une plaque frontale, caractérisé en ce qu'on prévoit dans une zone au moins adjacente à un rail profilé (30), à l'intérieur du support de groupes de composants, un dispositif de maintien (14) pour deux ressorts à lame (38, 48), de configuration différente pouvant être montés en option et qui peuvent être pressés chacun par un plot de contact (45) contre un point conducteur de la plaque de circuits (35) respective et qui se présentent soit sous la forme soit d'un ressort à lame (38) pouvant être pressé par un plot (41), contre le rail profilé (30), soit sous la forme d'un ressort à lame (48) qui présente un plot (51) faisant saillie par rapport au support de guidage (1), sur le côté opposé à la plaque de circuits (35), pour le raccordement d'une ligne.

2. Dispositif selon la revendication 1, caractérisé en ce que le dispositif de maintien (14) contient des points d'appui, disposés à l'extérieur du parcours de déplacement, pour les groupes de composants, destinés à une section centrale (39, 49) du ressort à lame respectif (38, 48) ainsi que respectivement une ouverture de passage, pratiquée dans le support de guidage (1), pour un premier et un deuxième plots (41, 50; 40, 51) qui, coudés dans la direction des ouvertures de passage, partent des extrémités de la section centrale (39, 49) et prennent appui contre des parties creuses (26, 21) des parois des ouvertures de passage.

3. Dispositif selon la revendication 1 ou 2, caractérisé en ce qu'un plot (41) du ressort à lame (38), reliant de manière conductrice une voie conductrice de la plaque de circuits au rail profilé (30), ressort par une ouverture de passage, et est pressé contre un côté du rail profilé (30), adjacent à l'ouverture de passage, tandis que l'autre plot (40) pénètre dans la partie creuse (21), par son extrémité coudée.

4. Dispositif selon la revendication 1 ou 2, caractérisé en ce qu'un plot (51) du ressort (48), reliant une voie conductrice de la plaque de circuits à la ligne, ressort par l'ouverture de passage éloignée du rail profilé (30), tandis que l'autre plot (50) prend appui, par son extrémité coudée, dans la partie creuse (26) du côté de l'autre ouverture de passage.

5. Dispositif selon l'une des revendications précédentes, caractérisé en ce qu'on prévoit sur au moins un côté frontal, un autre dispositif de maintien pour un ressort (15), qui contient un corps de base (57) en Z dont une extrémité, précontrainte par un ressort, peut être pressée contre un côté d'un évidement (32) du rail profilé (30), tandis que de l'autre extrémité du corps de base (57) qui est placée devant la face frontale, sous la rainure de guidage (22), fait saillie un ressort de contact (62) en forme de tulipe entre lequel on peut placer un ressort à lame (64) qui est relié à la plaque frontale (36) du groupe de composants.

6. Dispositif, selon l'une des revendications précédentes, caractérisé en ce qu'à proximité des deux extrémités, dans la direction longitudinale du rail profilé (30), sont disposés côte à côte un trou (27) aligné avec un évidement pratiqué dans le rail profilé (30) et un doigt de guidage (28) pouvant être introduit dans un trou du rail profilé, à côté duquel un crochet d'encliquetage (29), passant derrière le bord d'un évidement (32) du rail profilé (30), fait saillie du support de guidage (1).

7. Dispositif, notamment selon l'une des revendications 1 à 5, caractérisé en ce qu'à proximité des extrémités, on prévoit côte à côte, dans la direction longitudinale des rails profilés (30), un doigt de guidage qui pénètre dans un trou du rail profilé et un trou pour une vis de fixation et en ce qu'à côté du doigt de guidage et à côté du trou une paire de crochets d'encliquetage est disposée directement contre les bords du support de guidage, lesquels crochets s'encliquettent derrière un bord d'un évidement du rail profilé.

8. Dispositif, notamment selon l'une des revendications précédentes, caractérisé en ce qu'on prévoit deux barres longitudinales (3, 6) s'étendant le long des limites de la séparation respective entre les groupes de composants, dans le support de groupes de composants, lesquelles barres sont reliées entre elles par des traverses (10).

9. Dispositif selon la revendication 8, caractérisé en ce qu'une traverse (4) servant de surface de guidage pour un bord de plaque de circuits, fait saillie d'une barre longitudinale.

10. Dispositif selon la revendication 8 ou 9, caractérisé en ce que des parties saillantes (11) se dressent vers le haut, à partir des traverses (10), à côté de la surface de guidage.

## Claims

1. Device with at least one guide holder, which is connectable with profile rails of a sub-assembly carrier, for sub-assemblies which contain electrical or electronic components arranged on a circuit board and selectably a front plate, characterised thereby, that in at least one region adjoining a profile rail (30) inwardly in the subassembly carrier, a retaining equipment (14) is provided for two selectably insertable and differently constructed leaf springs (38, 48), which are each urgeable by a contact tag (45) against a conductive place of the respective circuit board (35) and which are constructed either as a leaf spring (38), which is urgeable by tag (41) against the profile rail (30), or as a leaf spring (48), which displays a tag (51), which projects beyond the guide holder (1) on the side opposite the circuit board (35), for the connection of a conductor.

2. Device according to claim 1, characterised thereby, that the retaining equipment (14) contains support locations, which arranged outside the displacement travel for the sub-assemblies, for a middle portion (39, 49) of the respective leaf spring (38, 48) as well as a respective passage opening in the guide holder (1) for a first and a second tag (41, 50; 40, 51), which each bent in the direction of the passage openings start out from the ends of the middle portion (39, 49) and bear against depression (26, 21) in the walls of the passage openings.

3. Device according to claim 1 or 2, characterised thereby, that a tag (41) of the leaf spring (38), which conductively connects a conductor track of the circuit board with the profile rail (30), projects beyond the one passage opening and is urged against a side, which adjoins the passage opening, of the profile rail (30), whilst the other tag (40) projects by its bent end into the depression (21).

4. Device according to claim 1 or 2, characterised thereby, that a tag (51) of the spring (48), which connects a conductor track on the circuit board with the conductor, projects beyond the passage opening remote from the profile rail (30), while the other tag (50) bears by its bent end in the depression (26) of the side of the other passage opening.

5. Device according to one of the preceding claims, characterised thereby, that a further retaining equipment for a spring (15) is provided at at least one end face and contains a z-shaped base body (57), the one end of which is urgeable under spring bias against a side of a recess (32) of the profile rail (30), whilst a tulip-shaped contact spring (62), between which a blade contact (64) is insertable, which is connected with the front plate (36) of the sub-assembly, projects from the other end of the base body (57), which is arranged underneath the guide groove (22) before the end face.

6. Device, in particular according to one of the preceding claims, characterised thereby, that a hole (27) aligned with a recess in the profile rail (30) and a guide pin (28), which is insertable into a hole of the profile rail and alongside which a detent hook (29), which engages behind an edge of a recess (32) of the profile rail (30), projects from the guide holder (1), are arranged one beside the other each time in longitudinal direction of the profile rail (30), near to both ends.

7. Device, in particular according to one of the claims 1 to 5, characterised thereby, that a guide pin, which engages into a hole of the profile rail, and a hole for a fastening screw are provided one beside the other each time in longitudinal direction of the profile rails (30) near to both ends and that a respective pair of detent hooks, which detent behind an edge of a recess of the profile rail, is arranged beside the guide pin and beside the hole and directly at the rims of the guide holder.

8. Device, in particular according to one of the preceding claims, characterised thereby, that two longitudinal strips (3, 6) are provided, which are connected one with the other by transverse webs (10) and extend along the boundaries of the respective sub-assembly division in the sub-assembly carrier.

9. Device according to claim 8, characterised thereby, that a transverse strip (4) project from a longitudinal strip as guide surface for a circuit board edge.

10. Device according to claim 8 or 9, characterised thereby, that projections (11) extend up beside the guide surface from the transverse webs (10).

# FIG.1

# FIG.2

# FIG.3

# FIG.4

# FIG.5

# FIG.6

# FIG.7